# EUROPÄISCHE PATENTSCHRIFT

(11) **EP 4 385 959 B1**
(45) Veröffentlichungstag und Bekanntmachung des Hinweises auf die Patenterteilung: **29.01.2025**
(21) Anmeldenummer: 23215143.1
(22) Anmeldetag: 08.12.2023
(51) Int. Cl.: C03C 3/087, C03C 3/093, C03C 3/097, C03C 10/00, C03C 21/00

(54) **TRANSPARENTE GLASKERAMIK, INSBESONDERE ALS DECKSCHEIBE**
TRANSPARENT GLASS CERAMIC, IN PARTICULAR AS A COVER PANE
VITROCÉRAMIQUE TRANSPARENTE, EN PARTICULIER COMME PLAQUE DE RECOUVREMENT

(30) Priorität: 16.12.2022 DE 102022133593
(43) Veröffentlichungstag der Anmeldung: 19.06.2024
(73) Patentinhaber: SCHOTT AG, 55122 Mainz (DE)
(72) Erfinder: SCHNEIDER, Meike, 55122 Mainz (DE); RÜDINGER, Bernd, 55122 Mainz (DE); MARTENS, Uwe, 55122 Mainz (DE)
(74) Vertreter: Schott Corporate IP

(56) Entgegenhaltungen:
- US-A1- 2020 239 354
- US-A1- 2022 081 348

## Beschreibung

Die vorliegende Erfindung betrifft eine transparente, chemisch vorspannbare oder chemisch vorgespannte Glaskeramik, ein Verfahren zu ihrer Herstellung, eine Deckscheibe aus einer solchen Glaskeramik und deren Verwendung sowie ein digitales Anzeigegerät, welches eine solche Deckscheibe umfasst.

Die Verwendung von Glas oder Glaskeramiken als Deckscheiben für elektronische Komponenten und Anzeigen, besonders für Smartphones ist seit langem bekannt. Bevorzugt werden diese glasbasierten Materialien chemisch vorgespannt, um ihre mechanische Festigkeit zu erhöhen.

Wie aus dem Bereich der Keramiken bekannt ist, haben mehrphasige Materialien, wie zum Beispiel faser-verstärkte Keramiken oder Gläser, eine intrinsisch höhere Festigkeit, da die Phasengrenzen die Rissausbreitung verringern oder unterdrücken. Das legt nahe, dass auch Glaskeramiken bereits ohne Vorspannung eine höhere Festigkeit aufweisen als ein Glas.

Als besonders geeignet haben sich hier Gläser und Glaskeramiken aus dem Li₂O-Al₂O₃-SiO₂-System, sog. LAS-Gläser und LAS-Glaskeramiken erwiesen. Sie weisen SiO₂ und Li₂O und Al₂O₃-als Hauptkomponenten auf. Die verwendeten Glaskeramiken lassen sich dabei nach ihren Hauptkristallphasen, d.h. den Kristallphasen, die den überwiegenden Anteil der Kristallphasen (mehr als 50 wt% der vorhandenen Kristallphasen) darstellen, unterteilen:
- Lithiumdisilikat- bzw. Lithiumdisilikat-Petalit-Glaskeramiken
- Hochquarz-Mischkristallglaskeramiken
- Keatit-Mischkristallglaskeramiken.

Lithiumdisilikat- bzw. Lithiumdisilikat-Petalit-Glaskeramiken weisen häufig gute optische Eigenschaften wie hohe Transmission und geringe Trübung ("haze") auf. Eine chemische Vorspannung basiert in diesen Materialien in der Regel auf einem Ionenaustausch mit der Restglasphase; ein Ionenaustausch in der Kristallphase, der wesentlich zur Erhöhung der mechanischen Festigkeit beiträgt, wird in der Regel nicht erreicht. Im Gegenteil führt der Ionenaustausch häufig zu einer Amorphisierung der vorgespannten Oberflächenschicht. Die positiven Effekte der Vorspannung und der glaskeramischen Mikrostruktur lassen sich hierbei also nicht kombinieren. Weiterhin müssen die zur Herstellung dieser Glaskeramiken verwendeten Zusammensetzungen mindestens 10 Gewichtsprozent Li₂O enthalten, um die Bildung einer ausreichenden Menge an Kristallphase zu gewährleisten. Im Zuge der verstärkten Nachfrage nach Li₂O in den letzten Jahren, z.B. für die Verwendung in Lithiumionenbatterien, kam es zu einem erheblichen Preisanstieg für Lithiumrohstoffe, was die Herstellung dieser Glaskeramiken erheblich verteuert.

Glaskeramiken mit der Hauptkristallphase Hochquarz-Mischkristall sind ebenfalls seit langem bekannt. Sie werden vielfach zur Herstellung von Kochflächen, Spiegelträgern usw. verwendet, da sie eine geringere thermischen Dehnung mit hoher Transparenz und guter industrieller Herstellbarkeit vereinen. Mit Li₂O-Gehalten von 2 bis 6 Gew.-% sind sie zudem günstiger in der Herstellung. Für die Verwendung als Deckgläser sind sie jedoch nur bedingt geeignet, da die chemische Vorspannung schwierig ist und ebenfalls nur über die amorphe Restglasphase erfolgt.

Glaskeramiken mit der Hauptkristallphase Keatit, die sich durch Temperung aus den Hochquarz-Mischkristall-Glaskeramiken herstellen lassen, weisen häufig eine erhöhte Streuung auf, die die optische Transmission der Glaskeramik verringert und zu einer unerwünschten Trübung führt.

Im Stand der Technik sind die theoretischen Bedingungen bekannt, die erfüllt sein müssen, um einen transparente Glaskeramik herzustellen (Höland, Beall): Der Unterschied des Brechwertes zwischen Kristallphase und Restglasphase und die Kristallitgröße sollten möglichst gering sein. Besonders die geringe Kristallitgröße ist bei Keatit-Mischkristallglaskeramiken nur schwer zu erreichen (übliche Kristallitgrößen liegen im Bereich von > 100 nm), so dass meistens transluzente oder opake Glaskeramiken erhalten werden. Transparente Keatit-Mischkristallglaskeramiken für die Verwendung als Deckgläser wurden z.B. in der Anmeldung DE 10 2021 132 738.5 der Anmelderin beschrieben. Der Vorspannprozess erfolgt bei diesen Glaskeramiken über eine Vorspannung der Kristallphase, was die oben genannten Nachteile der Vorspannung der amorphen Phase wie in Lithiumdisilikat-Glaskeramiken behebt und zu außergewöhnlich guten Vorspannergebnissen führt.

Ebenfalls aus dem Stand der Technik ist bekannt, dass die Keimbildung in den transparenten Hochquarz- oder Keatit-Mischkristall-Glaskeramiken bevorzugt über eine Mischkeimbildung erfolgt. Verwendet werden hier vor allem die Keimbildnerkombinationen TiO_{2/}ZrO₂ oder SnO2/ZrO2, wie zum Beispiel US 2022/081348 oder US 2020/239354. Auch eine Kombination aller drei Keimbildner, d.h. TiO₂/ZrO₂/SnO₂ ist möglich. Die Keimbildung mit TiO₂/ZrO₂ hat den Nachteil, dass das als Keimbildner genutzte TiO₂ mit Fe₂O₃ einen färbenden Ilmenit-Komplex bildet, was zu einer unerwünschten Gelb-Braunfärbung der Glaskeramik führt. Bei gleichzeitigem Vorliegen von SnO₂ in der Zusammensetzung tritt ebenfalls eine Gelbverfärbung auf. Diese Färbungen können durch die Reduktion des Fe₂O₃-Gehalts in den Rohstoffen vermieden werden, was allerdings mit höheren Rohstoffkosten verbunden ist und deshalb kein bevorzugter Weg für eine industrielle Herstellung ist.

Die SnO_{2/}ZrO₂-Keimbildung hat diesen Nachteil nicht. Allerdings führen diese Keimbildner leicht zu hohen Verarbeitungstemperaturen und verstärkter Entglasungsneigung. Beides zusammen erschwert eine wirtschaftliche Herstellbarkeit dieser Glaskeramiken.

Die Aufgabe der vorliegenden Erfindung ist es daher, eine transparente, chemisch vorspannbare Glaskeramik mit Keatit als Hauptkristallphase für die Verwendung als Deckglas bereitzustellen, die eine hohe Transmission, nämlich eine Transmission von τᵥᵢₛ ≥ 80 % bei einer Dicke von 0,7 mm, eine geringe Trübung, ausgedrückt durch haze ≤ 10, und einen hohen Keatitanteil, nämlich einen Kristallphasenanteil von mindestens 80 Gew.-% Keatitmischkristall bezogen auf alle in der Glaskeramik vorliegenden Kristallphasen aufweist, wobei eine unerwünschte Färbung vermieden wird. Weitere Aspekte betreffen ein Verfahren zur Herstellung einer solchen Glaskeramik sowie deren Verwendung als Deckscheibe.

Die Aufgabe der Erfindung wird gelöst durch den Gegenstand der unabhängigen Ansprüche. Spezielle und bevorzugte Ausgestaltungen finden sich in den abhängigen Ansprüchen sowie in Beschreibung der vorliegenden Offenbarung.

Die erfindungsgemäße Glaskeramik enthält einen hohen Kristallphasenanteil an Keatit von mindestens 80 Gew.-% Keatitmischkristall, bevorzugt mindestens 90 Gew.-%, besonders bevorzugt mind. 95 Gew.-% bezogen auf alle Kristallphasen in der Glaskeramik. Dieser hohe Anteil an Keatitmischkristallen am Gesamtkristallgehalt stellt die gute Vorspannbarkeit der Glaskeramik sicher. Weiterhin können Keimbildnerkristalle, d.h. Kristalle, die die Keimbildner ZrO₂ und/oder SnO₂ und/oder SnZrO₄-Mischkristall enthalten, vorliegen. Weitere Kristallphasen wie Hochquarz-Mischkristall oder Spinelle, z.B. Gahnite liegen bevorzugt nicht vor, da sie die Transmission verringern können und/oder zu einer Trübung der Glaskeramik führen können. Die Menge der amorphen Restglasphase der Glaskeramik beträgt bevorzugt weniger als 40 Gew.-%, besonders bevorzugt zwischen 2 Gew.-% und 30 Gew.-% oder zwischen 5 Gew.-% und 30 Gew.-%. Die Kristallitgröße der Keatitmischkristalle ist, um eine hohe Transparenz zu gewährleisten, kleiner als 100 nm, bevorzugt maximal 80 nm.

Die Glaskeramik umfasst in einer bevorzugten Ausführungsform als Hauptkomponenten die Bestandteile SiO₂, Al₂O₃ und Li₂O sowie als Keimbildner SnO₂ und ZrO₂. Unter Hauptkomponenten im Sinne der vorliegenden Erfindung wird verstanden, dass die Summe dieser Komponenten 85 % oder mehr (in Massenprozent) der Glaskeramik beträgt. Die Begriffe Massenprozent und Gewichtsprozent, abgekürzt als Gew.-%, werden im Rahmen der vorliegenden Offenbarung synonym verwendet.

Die Menge dieser Komponenten beträgt in bevorzugten Ausführungsformen in Massenprozent:
SiO₂ 58 - 72 %, bevorzugt 65 - 70 %,
   und/oder
Al₂O₃ 18 - 23 %
   und/oder
Li₂O 2 - 5,5 %, bevorzugt 3 - 5 %,
   und/oder
SnO₂ 1 - 2 %, bevorzugt 1- 1,5 %,
   und/oder
ZrO₂ 2 - 3 %, bevorzugt 2,1-2,9 %

Als besonders vorteilhaft für die Transmission der resultierenden Glaskeramik ist es, wenn das Verhältnis (jew. bezogen auf Massenprozent) von Al₂O₃ zu SiO₂ kleiner als 0,33 ist. Allerdings sollte das Verhältnis vorzugsweise auch nicht kleiner als 0,2 sein, da sonst die Viskosität des Glases so hoch wird, dass schmelztechnische Herstellung und Formgebung erschwert werden.

Li₂O soll als wesentlicher Bestandteil des Kristalls mit mindestens 2 Gew.-% in der Glaskeramik enthalten sein. Die Gesamtmenge wird jedoch aus wirtschaftlichen Erwägungen begrenzt, da sich die Menge direkt auf die Rohstoffkosten auswirkt. In einer bevorzugten Ausführungsform enthält die Glaskeramik daher maximal 5 Gew.-% Li₂O.

Die Menge an Keimbildnern wird so gewählt, dass eine gute Keimbildungswirkung bei wirtschaftlich sinnvollen Keimbildungszeiten (in der Regel einige Minuten bis zu wenigen Tagen) erreicht wird. Unter einer guten Keimbildungswirkung ist in diesem Zusammenhang zu verstehen, dass ausreichend viele Keimbildungskristalle gebildet werden, dass die darauf aufwachsenden Kristalle eine maximale Größe von 100 nm nicht überschreiten, wobei die Größe der Kristalle durch Verfügbarkeit der Kristallitbestandteile und/oder das "Anstoßen" an andere Kristallite begrenzt wird. Gleichzeitig sollte ein Überschuss an Keimbildnern vermieden werden. Größere Mengen an SnO₂ und ZrO₂ führen wie oben beschrieben zu einer Erhöhung der Entglasungsneigung. Die Summe der Keimbildner SnO₂+ZrO₂ sollte dennoch vorzugsweise größer als 3,6 Gew.-%, bevorzugt größer als 3,8 Gew.-% sein. Die Summe der Keimbildner SnO₂+ZrO₂ sollte aber vorzugsweise auf maximal 5 Gew.-% beschränkt sein.

Die Glaskeramik sollte bevorzugt frei von TiO₂ sein, um einer unerwünschten Färbung durch den oben beschriebenen Ilmenit-Komplex vorzubeugen.

Die Glaskeramik kann neben Li₂O weitere Alkalioxide enthalten, bevorzugt Na₂O und/oder K₂O bis zu 1 Gew.-%, um die Schmelzbarkeit des Glases zu verbessern. Höhere Mengen an Alkalioxiden können zur Bildung von unerwünschten Nebenphasen führen, die sich in der Regel negativ auf optische oder mechanische Eigenschaften der Glaskeramik auswirken. Die Summe von Na₂O + K₂O sollte daher höchstens ein Gewichtsprozent betragen, bevorzugt ist sie kleiner oder gleich 0,5 Gew.-%.

Um die Viskosität des Grünglases abzusenken und damit die Herstellbarkeit zu verbessern können Erdalkalioxide und/oder ZnO eingesetzt werden.

Die Komponente MgO nimmt eine Sonderstellung unter den Erdalkalioxiden ein, da sie in den Kristall eingebaut werden kann. Größere Erdalkalioxide verbleiben dagegen in der Restglasphase. Die Menge und Auswahl der Erdalkalioxide beeinflusst daher direkt den Brechungsindex der Restglasphase und damit die Transmission bzw. Trübung.

Es hat sich gezeigt, dass MgO in den erfindungsgemäßen Glaskeramiken einen negativen Einfluss auf die Transmission hat, die Glaskeramik ist daher frei von MgO.

CaO ist, wenn vorhanden, vorzugsweise bis zu 1 Gew.-% vorhanden, bevorzugt beträgt sein Anteil weniger als 0,8 Gew.-%; größere Anteile an CaO können zu einer Verringerung der Transmission führen.

Die größeren Erdalkalien wie SrO und BaO erhöhen den Brechungsindex der Restglasphase. Im Gegensatz zu Glaskeramiken, die mit TiO₂ und ZrO₂ gekeimt wurden, führt diese jedoch bei Glaskeramiken mit SnO₂-ZrO₂-Keimbildung zu einer Verringerung der Transmission. Die erfindungsgemäße Glaskeramik enthält daher in einer Ausführungsform weniger als 2 Gew.- % SrO und/oder BaO, bevorzugt beträgt der Gehalt an SrO 0 - 1,8 Gew.-% und/oder ist die Glaskeramik frei von BaO.

Aus demselben Grund ist es vorteilhaft, die Summe an SrO + CaO auf maximal 1,8 Gew.-%, bevorzugt 1,5 Gew.-% zu begrenzen.

Die Komponente ZnO wirkt sich ebenfalls positiv auf die Transmission und die Viskosität aus, die Glaskeramik enthält bevorzugt 0,3 bis 1,8 Gew.-% ZnO.

Überraschenderweise wurde gefunden, dass die Komponenten Li₂O, ZnO und CaO die Transmission in ihrem Zusammenspiel beeinflussen: Die Bedingung Li₂O - ZnO - CaO < 3 Gew.- % sollte erfüllt sein, um eine besonders hohe Transmission zu erreichen.

Die Glaskeramik kann in Ausführungsformen bis zu 2 Gew.-% der üblichen Läutermittel wie As2O3, Sb2O3, Halogenide oder schwefelhaltige Verbindungen enthalten. Da das als Keimbildner enthaltene SnO₂ ebenfalls als Läutermittel wirkt, kann auf den Einsatz eines weiteren Läutermittels in der Regel verzichtet werden. Bevorzugt ist die Glaskeramik aus Gründen des Umwelt- und Arbeitsschutzes im wesentlichen frei von Arsen und Antimon. Dies gilt auch für andere giftige oder umweltschädliche Komponenten wie PbO, TeO₂, CdO usw. Unter "im wesentlichen frei" wird verstanden, dass nur Verunreinigungen, die bei üblicher und wirtschaftlicher Vorgehensweise unvermeidlich sind (z.B. durch Rohstoffe), enthalten sind.

Die Glaskeramik ist außerdem vorzugsweise im Wesentlichen frei von färbenden Komponenten, insbesondere frei von V₂O₅, färbenden seltenen Erden wie Nd₂O₃, Er₂O₃, CeO₂, und färbenden Metalloxiden wie CoO, NiO, Cr₂O₃ oder CuO.

Der Eisengehalt der Glaskeramik, angegeben in Gewichtsprozent Fe₂O₃, sollte vorzugsweise weniger als 1000 ppm betragen, besonders bevorzugt weniger als 500 ppm, um eine unerwünschte Färbung des Materials zu vermeiden. Der Eisengehalt der Glaskeramik ergibt sich dabei durch unvermeidliche Verunreinigungen der Rohstoffe. Durch den Einsatz eisenarmer Rohstoffe kann die Menge an Eisen vermindert werden und eine bessere (neutralere) Eigenfarbe der Glaskeramik erreicht werden, dies ist allerdings in der Regel mit höheren Rohstoffkosten verbunden.

Die Glaskeramik kann B₂O₃ enthalten. Wenn vorhanden, ist B₂O₃ vorzugsweise mit bis zu 2 Gew.-% enthalten, um die Viskosität zu reduzieren. Höhere Gehalte an B₂O₃ sollten vermieden werden, da sich gezeigt hat, dass B₂O₃ die Vorspannbarkeit der Glaskeramik negativ beeinflussen kann.

Die erfindungsgemäße Glaskeramik soll im wesentlichen frei von P₂O₅ sein.

Die erfindungsgemäße Glaskeramik eignet sich für die Herstellung einer Deckscheibe zum Beispiel in elektronischen Geräten, insbesondere in elektronischen Anzeigegeräten, insbesondere in mobilen elektronischen Anzeigegeräten, beispielsweise in mobile touch panels und/oder mobilen digitalen Anzeigegeräten wie Smartphones oder Smartwatches und allgemein Touchpanels.

Die Deckscheibe weist vorzugsweise eine Dicke von 0,4 mm bis 1 mm auf.

Das Verfahren zur Herstellung einer Glaskeramik umfasst die Schritte:
- Herstellen eines silikatischen Grünglases durch einen Schmelzprozess und eine anschließende Heißformgebung.
- Temperaturbehandlung des silikatischen Grünglases, wobei mindestens ein Keimbildungsschritt im Temperaturbereich von 690 °C bis 850 °C für eine Dauer von 5 Minuten bis 72 Stunden, bevorzugt 30 Minuten bis 2 Stunden, und mindestens ein Keramisierungsschritt im Temperaturbereich von 780 °C bis 1100 °C für eine Dauer von 3 Minuten bis 150 Stunden, bevorzugt 3 Minuten bis 8 Stunden, durchgeführt werden.

Zur Herstellung einer vorgespannten Glaskeramik, insbesondere nach einer Ausführungsform zur Verwendung als Deckscheibe, schließt sich an die beiden obigen Schritte der folgende an:
- Durchführen wenigstens eines Ionenaustauschs in einem Tauschbad mit einer Zusammensetzung von 100 Gew.-% bis 0 Gew.-% KNO₃ und 0 Gew.-% bis 100 Gew.-% NaNO₃ und 0 Gew.-% bis 5 Gew.-% LiNO₃ bei einer Temperatur des Tauschbads zwischen 370°C und 500°C und einer Dauer zwischen 2 Stunden und 50 Stunden.

Die Heißformgebung kann ohne Beschränkung der Allgemeinheit zum Beispiel durch Floaten, Walzen, Ziehen oder Blockguss erfolgen.

Die Deckscheibe aus vorgespannter Glaskeramik ist nicht nur transparent, sondern auch farbneutral und hochfest.

Unter einem Tauschbad wird eine Salzschmelze verstanden, wobei diese Salzschmelze in einem Ionenaustauschverfahren für ein Glas oder einen Glasartikel zum Einsatz kommt. Im Rahmen der vorliegenden Offenbarung werden die Begriffe des Tauschbads und des Ionenaustauschbads synonym verwendet.

In der Regel werden für Tauschbäder Salze in technischer Reinheit verwendet. Dies bedeutet, dass trotz der Verwendung von beispielsweise lediglich Natriumnitrat als Ausgangsstoff für ein Tauschbad noch gewisse Verunreinigungen vom Tauschbad umfasst sind. Das Tauschbad ist dabei eine Schmelze eines Salzes, beispielsweise also von Natriumnitrat, oder eines Gemischs von Salzen, beispielsweise ein Gemisch von einem Natrium- und einem Kaliumsalz. Dabei wird die Zusammensetzung des Tauschbades in der Form angegeben, dass sie sich auf die nominelle Zusammensetzung des Tauschbades ohne Berücksichtigung von eventuell vorhandenen Verunreinigungen bezieht. Sofern daher im Rahmen der vorliegenden Offenbarung von einer 100%igen Natriumnitratschmelze gesprochen wird, bedeutet dies also, dass als Rohstoff lediglich Natriumnitrat verwendet wurde. Der tatsächliche Gehalt des Tauschbades an Natriumnitrat kann jedoch davon abweichen und wird dies in der Regel auch, da insbesondere technische Rohstoffe einen gewissen Anteil an Verunreinigungen aufweisen. Dieser liegt jedoch in der Regel bei weniger als 5 Gew.-%, bezogen auf das Gesamtgewicht des Tauschbads, insbesondere bei weniger als 1 Gew.-%.

In entsprechender Weise werden bei Tauschbädern, welche ein Gemisch verschiedener Salze aufweisen, die nominellen Gehalte dieser Salze ohne Berücksichtigung von technisch bedingten Verunreinigungen der Ausgangsstoffe angegeben. Ein Tauschbad mit 90 Gew.-% KNO₃ und 10 Gew.-% NaNO₃ kann also ebenfalls noch geringe Verunreinigungen aufweisen, welche jedoch durch die Rohstoffe bedingt sind und in der Regel bei weniger als 5 Gew.-%, bezogen auf das Gesamtgewicht des Tauschbads, insbesondere bei weniger als 1 Gew.-%, liegen sollten.

Weiterhin ändert sich die Zusammensetzung des Tauschbades auch im Laufe des Ionenaustauschs, da durch den fortgesetzten Ionenaustausch insbesondere Lithiumionen aus dem Glas bzw. dem Glasartikel in das Tauschbad migrieren. Eine solche Änderung der Zusammensetzung des Tauschbades durch Alterung wird vorliegend allerdings ebenfalls, sofern nicht ausdrücklich anders angegeben, nicht berücksichtigt. Vielmehr wird im Rahmen der vorliegenden Offenbarung bei der Angabe der Zusammensetzung eines Tauschbads auf die nominelle ursprüngliche Zusammensetzung abgestellt.

Im Folgenden wird die Erfindung anhand von Beispielen näher erläutert.

Die Zusammensetzungen erfindungsgemäßer glaskeramischer Materialien finden sich in Tabelle 1 (alle Angaben in Gewichtsprozent). Die Abkürzung MO steht für die Summe der Erdalkalioxide und ZnO.

Die in Tabelle 1 aufgeführten Materialien wurden unter Verwendung von in der Glasindustrie üblichen Rohstoffen bei Temperaturen von ca. 1600 °C bis 1680 °C erschmolzen und geläutert. Das Aufschmelzen des Gemenges erfolgte dabei zunächst in Tiegeln aus gesintertem Kieselglas und wurde dann in Pt/Rh-Tiegel mit Innentiegeln aus Kieselglas umgegossen und bei Temperaturen von ca. 1550 °C für 30 Minuten durch Rühren homogenisiert. Nach Abstehen bei 1640 °C für 2 h wurden Gussstücke von ca. 140 mm x 100 mm x 30 mm Größe gegossen und in einem Kühlofen bei ca. 620 °C bis 680 °C entspannt und auf Raumtemperatur abgekühlt. Aus den Gussstücken wurden die Prüfmuster für die Messung der Eigenschaften im glasigen Zustand und für die Keramisierungen präpariert. Für die Keramisierungen wurden in der Regel zweistufige Programme verwendet, die in Tabelle 1 angegeben sind. Hierbei werden die Ausgangsgläser von Raumtemperatur zunächst auf eine Keimbildungstemperatur oberhalb von T_{g} erhitzt und dort eine für die Keimbildung ausreichende Zeit lang gehalten. Anschließend werden die Proben auf die Keramisierungstemperatur erhitzt und dort ebenfalls gehalten. Auch drei- oder mehrstufige Programme können verwendet werden. Haltezeiten für die Keimbildung liegen zwischen 5 min bis 72 h, bevorzugt 30 min bis 2 h und gefolgt von einem Keramisierungsschritt von 3 min bis 150 h, bevorzugt 3 min bis 8 h. Haltezeiten können weiterhin durch langsame Heizraten ersetzt werden.

An den keramisierten Proben wurden mittels XRD die Kristallphasen und deren Gehalte sowie die Transmission im sichtbaren Bereich τᵥᵢₛ [%] (an Proben mit 0,7 mm Dicke) sowie die Farbwerte im Lab-System (Normlichtart D65) bestimmt.

Die Messung des Haze erfolgte mit einem Haze-Gard dual der Firma BYK Additives & Instruments entsprechend der ASTM D 1003 und ISO 14782 Norm (an Proben mit 0,7 mm Dicke).

Die in Tabelle 1 in Gew.-% angegebenen Kristallphasengehalte bezogen auf alle in der Glaskeramik vorliegenden Kristallphasen wurden mit Hilfe von Röntgenbeugungsmessungen an einem Panalytical X'Pert Pro Diffraktometer (Almelo, Niederlande) bestimmt. Als Röntgenstrahlung wurde eine über einen Ni-Filter erzeugte CuKα-Strahlung (λ = 1.5060 Ä) verwendet. Die Standard-Röntgenbeugungsmessungen an Pulver- als auch Festkörperproben wurden unter einer Bragg-Brentano-Geometrie (θ-2θ) durchgeführt. Die Röntgenbeugungsdiagramme wurden zwischen 10° und 100° (2θ-Winkel) gemessen. Die Quantifizierung der relativen kristallinen Phasenanteile sowie die Bestimmung der Kristallitgrößen erfolgte über eine Rietveld-Analyse. Die Messung erfolgte an gemahlenem Probenmaterial, wodurch der Volumenanteil des Kernbereichs deutlich dominiert. Die gemessenen Phasenanteile entsprechen daher der Phasenverteilung im Kern der Glaskeramik. KMK steht für Keatit-Mischkristall, HQMK für Hochquarzmischkristall. Die Proben mit "V" entsprechen Vergleichsbeispielen. Die lediglich nummerierten Beispiele sind Beispiele von Ausführungsformen. Die Abkürzung "n.b." steht für "nicht bestimmt".

**Tabelle 1**

| | 1 | 2 | V1 | V2 | 3 | 4 | V3 | 5 | 6 |
|---|---|---|---|---|---|---|---|---|---|
| Al₂O₃ | 18,63 | 18,52 | 18,47 | 18,66 | 18,39 | 19,20 | 18,11 | 18,31 | 18,43 |
| B₂O₃ | | 0,40 | | | | | | | |
| CaO | 0,20 | 0,20 | 0,20 | 1,01 | 0,80 | 0,20 | 0,20 | 0,20 | 0,21 |
| Fe₂O₃ | 0,013 | 0,013 | 0,013 | 0,014 | 0,014 | 0,013 | 0,013 | 0,012 | 0,012 |
| K₂O | 0,47 | 0,47 | 0,93 | 0,47 | 0,46 | 0,46 | 0,46 | 0,46 | 0,47 |
| Li₂O | 4,51 | 4,40 | 4,42 | 4,47 | 4,36 | 4,52 | 4,93 | 4,38 | 4,42 |
| Na₂O | 0,49 | 0,48 | 0,96 | 0,58 | 0,47 | 0,47 | 0,49 | 0,47 | 0,48 |
| P₂O₅ | | | | 0,02 | | | | 2,12 | |
| SiO₂ | 69,70 | 69,40 | 69,00 | 68,30 | 69,30 | 68,80 | 69,60 | 68,20 | 69,10 |
| SnO₂ | 1,41 | 1,46 | 1,45 | 1,45 | 1,46 | 1,47 | 1,47 | 1,42 | 1,43 |
| SrO | 0,49 | 0,50 | 0,49 | 0,98 | 0,77 | 0,49 | 0,49 | 0,49 | 1,43 |
| TiO₂ | 0 | | | | | | | | |
| ZnO | 1,44 | 1,53 | 1,43 | 1,44 | 1,43 | 1,94 | 1,64 | 1,41 | 1,43 |
| ZrO₂ | 2,50 | 2,52 | 2,49 | 2,50 | 2,49 | 2,33 | 2,50 | 2,46 | 2,47 |
| Summe | 99,85 | 99,90 | 99,85 | 99,89 | 99,95 | 99,90 | 99,91 | 99,94 | 99,88 |
| Na₂O + K₂O | 0,95 | 0,96 | 1,89 | 1,05 | 0,93 | 0,93 | 0,95 | 0,94 | 0,95 |
| CaO + SrO | 0,69 | 0,70 | 0,69 | 1,99 | 1,57 | 0,69 | 0,69 | 0,69 | 1,64 |
| Li2O - ZnO - CaO | 2,870 | 2,670 | 2,790 | 2,020 | 2,132 | 2,380 | 3,090 | 2,770 | 2,780 |
| ZrO₂ + SnO₂ | 3,910 | 3,980 | 3,940 | 3,950 | 3,950 | 3,800 | 3,970 | 3,880 | 3,900 |
| Al₂O_{3/}SiO₂ | 0,27 | 0,27 | 0,27 | 0,27 | 0,27 | 0,28 | 0,26 | 0,27 | 0,27 |
| Tg | 686 | 696 | 705 | 698 | n.b. | 678 | 672 | 680 | 680 |
| Keimbildung | 740°C | 735°C | 745°C | 740°C | 745°C | 700-760°C | 740°C | 740°C | 690-750°C |
| Keramisierung | 880°C | 875°C | 825°C | 850°C | 835°C | 840°C | 880°C | 880°C | 830°C |
| τvis | 90,30 | 90,4 | 65,30 | opak | 83,00 | 89,80 | transluzent-opak | 84,90 | 86,6 |
| c* | 1,2 | 2,5 | 12,40 | n.b. | 6,5 | 1,4 | n.b. | 6,4 | 4,2 |
| L* | 96,1 | 96,1 | 84,70 | n.b. | 93,0 | 95,9 | n.b. | 93,8 | 94,6 |
| a* | -0,2 | -0,2 | 0,60 | n.b. | -0,4 | -0,2 | n.b. | -0,7 | -0,4 |
| b* | 1,1 | 1,4 | 12,30 | n.b. | 6,4 | 1,4 | n.b. | 6,4 | 4,2 |
| C | n.b. | 2,6 | 25,00 | n.b. | 11,9 | 2,6 | n.b. | n.b. | n.b. |
| Haze | 0,46 | 0,5 | 88,97 | n.b. | 5,2 | 0,73 | n.b. | n.b. | n.b. |
| KMK Phasengehalt [Gew.- %] | 98,4 | 98,50 | 98,60 | 97,9 | 98,10 | 98,3 | 97,7 | 98,1 | 97,9 |
| Keimbildner Phasengehalt [Gew.-%] | 1,6 | 1,50 | 1,40 | 1,3 | 1,50 | 1,7 | 1,7 | 1,5 | 1,7 |
| SnO₂ Phasengehalt [Gew.- %] | 0 | 0,00 | 0,00 | 0,8 | 0,40 | 0 | 0,6 | 0,4 | 0,4 |
| KMK Kristallitgr. [nm] | 65 | 69 | 70,00 | 82 | 75 | 69 | 88 | 72 | 73 |

Die Beispiele 1 bis 4 und 6 zeigen erfindungsgemäße transparente Glaskeramiken mit hoher Transparenz und geringer Trübung.

Das Vergleichsbeispiel V1 zeigt die negative Auswirkung eines hohen Alkaligehalts. So sank bei dieser Zusammensetzung die Transmission auf 65 %.

Im Vergleichsbeispiel V2 wurde 1 Gew.-% CaO eingesetzt, bei dieser Zusammensetzung wird die Glaskeramik dadurch opak, während bei 0,8 % im Beispiel 3 die Transmission noch bei 83 % liegt. Diese Konzentration ist damit als grenzwertig zu betrachten.

Vergleichsbeispiel V3 verdeutlicht die Bedeutung, die die Bedingung Li₂O - ZnO - CaO < 3 haben kann. Bei diesem Beispiel lässt sich eine gute Transmission nicht erreichen.

Referenzbeispiel 5 enthält 2 Gew.-% P₂O₅. Dies kann zu einer Reduktion der Viskosität und damit der benötigten Verarbeitungstemperaturen führen, wirkt sich allerdings wie im Beispiel ersichtlich bereits negativ auf die Transparenz aus.

An den Beispielen 1, 2, 3 und 4 wurde zudem der Haze bestimmt. Es zeigt sich, dass die Beispiele 1, 2 und 4, die im besonders bevorzugten Zusammensetzungsbereich der Erfindung liegen, besonders niedrige Haze-Werte von weniger als 1 aufweisen.

## Patentansprüche

1. Transparente, chemisch vorspannbare oder chemisch vorgespannte Glaskeramik mit Keatit als Hauptkristallphase, die eine Transmission von τᵥᵢₛ ≥ 80 % bei einer Dicke von 0,7 mm, eine geringe Trübung ausgedrückt durch haze ≤ 10, bevorzugt < 5, und einen Kristallphasenanteil von mindestens 80 Gew.-% Keatitmischkristall, bevorzugt mindestens 90 Gew.-%, besonders bevorzugt mind. 95 Gew.-%, bezogen auf alle Kristallphasen in der Glaskeramik aufweist und die wenigstens 2 Gew.-% Li₂O enthält und im wesentlichen frei von MgO und im wesentlichen frei von P₂O₅ ist.

2. Glaskeramik nach Anspruch 1 **dadurch gekennzeichnet, dass** sie SiO₂, Al₂O₃ und Li₂O als Hauptkomponenten sowie SnO₂ und ZrO₂ als Keimbildner aufweist.

3. Glaskeramik nach einem der Ansprüche 1 oder 2 **dadurch gekennzeichnet, dass** der SiO₂-Gehalt in Gewichtsprozent 58 bis 72 beträgt, bevorzugt 65 bis 70.

4. Glaskeramik nach einem der vorhergehenden Ansprüche **dadurch gekennzeichnet, dass** der Al₂O₃-Gehalt in Gewichtsprozent 18 bis 23 beträgt.

5. Glaskeramik nach einem der vorhergehenden Ansprüche **dadurch gekennzeichnet, dass** der Li₂O-Gehalt in Gewichtsprozent 2 bis 5,5 beträgt, bevorzugt 3 bis 5.

6. Glaskeramik nach einem der vorhergehenden Ansprüche **dadurch gekennzeichnet, dass** sie 1 bis 2 Gew.-% SnO₂, bevorzugt 1 bis2,5 Gew.-% SnO₂, und/oder 2 bis 3 Gew.-% ZrO₂ enthält.

7. Glaskeramik nach einem der vorhergehenden Ansprüche **dadurch gekennzeichnet, dass** sie weniger als 0,1 Gew.-% TiO₂, bevorzugt im wesentlichen frei von TiO₂ ist.

8. Glaskeramik nach einem der vorhergehenden Ansprüche **dadurch gekennzeichnet, dass** das Verhältnis von Al₂O₃ zu SiO₂, beides in Gewichtsprozent, Al₂O_{3/}SiO₂ < 0,33 ist.

9. Glaskeramik nach einem der vorhergehenden Ansprüche **dadurch gekennzeichnet, dass** sie im wesentlichen frei von färbenden Komponenten ist, insbesondere frei von V₂O₅, Nd₂O₃, CoO ist.

10. Glaskeramik nach einem der vorhergehenden Ansprüche **dadurch gekennzeichnet**, 0-2 % B₂O₃ enthält.

11. Glaskeramik nach einem der vorhergehenden Ansprüche **dadurch gekennzeichnet, dass** sie weniger als 1 % Na₂O + K₂O enthält.

12. Glaskeramik nach einem der vorhergehenden Ansprüche **dadurch gekennzeichnet, dass** die Bedingung Li₂O - ZnO - CaO < 3 % erfüllt ist.

13. Glaskeramik nach einem der vorhergehenden Ansprüche **dadurch gekennzeichnet, dass** sie weniger als 2 Gew.-% BaO, bevorzugt im wesentlichen frei von BaO ist.

14. Glaskeramik nach einem der vorhergehenden Ansprüche **dadurch gekennzeichnet, dass** sie weniger als 1,8 Gew. % CaO + SrO enthält, bevorzugt weniger als 1,5 %, wobei der Gehalt an CaO bevorzugt 0 bis 1 Gew.-% beträgt, besonders bevorzugt 0 bis 0,8 %, und der Gehalt an SrO bevorzugt weniger als 1,8 Gew.-% beträgt.

15. Glaskeramik nach einem der vorhergehenden Ansprüche **dadurch gekennzeichnet, dass** sie 0 bis 2 Gew.-% ZnO enthält, bevorzugt 0,8 bis 2 %.

16. Glaskeramik nach einem der vorhergehenden Ansprüche **dadurch gekennzeichnet, dass** die Summe ZrO₂+ SnO₂ > 3,6 Gew.-% ist, bevorzugt > 3,8 % ist.

17. Glaskeramik nach einem der vorhergehenden Ansprüche **dadurch gekennzeichnet, dass** sie bis zu 2 % von einem oder mehreren Läutermitteln ausgewählt aus As₂O₃, Sb₂O₃, Halogenide, SO₃ enthält.

18. Verfahren zur Herstellung einer vorgespannten Glaskeramik nach einem der Ansprüche 1 bis 16, umfassend die Schritte
- Herstellen eines silikatischen Grünglases durch einen Schmelzprozess und eine anschließende Heißformgebung
- Temperaturbehandlung des silikatischen Grünglases, wobei mindestens ein Keimbildungsschritt im Temperaturbereich von 690 °C bis 850 °C für eine Dauer von 5 min bis 72 h, bevorzugt 30 min bis 2 h, und mindestens ein Keramisierungsschritt im Temperaturbereich von 780 °C bis 1100 °C für eine Dauer von 3 min bis 150 h, bevorzugt 3 min. bis 8 h, durchgeführt wird
- Durchführen wenigstens eines Ionenaustauschs in einem Tauschbad mit einer Zusammensetzung von 100 Gew.-% bis 0 Gew.-% KNO₃ und 0 Gew.-% bis 100 Gew.-% NaNO₃ und 0 Gew.-% bis 5Gew.-% LiNO₃ bei einer Temperatur des Tauschbads zwischen 370°C und 500°C und einer Dauer zwischen 2 Stunden und 50 Stunden.

19. Verfahren nach Anspruch 18, wobei die Heißformgebung durch Floaten, Walzen, Ziehen oder Blockguss erfolgt.

20. Deckscheibe mit einer Dicke von 0,4 mm bis 1 mm hergestellt aus einer vorgespannten Glaskeramik nach einem der Ansprüche 1 bis 17 oder nach einem Verfahren gemäß Anspruch 18 oder 19.

21. Verwendung einer Deckscheibe nach Anspruch 20 und/oder einer vorgespannten Glaskeramik nach einem der Ansprüche 1 bis 17 in elektronischen Geräten, insbesondere in elektronischen Anzeigegeräten, insbesondere in mobilen elektronischen Anzeigegeräten, beispielsweise in mobile touch panels und/oder mobilen digitalen Anzeigegeräten wie Smartphones oder Smartwatches.

22. Anzeigegerät, insbesondere digitales Anzeigegerät, umfassend wenigstens eine Deckscheibe nach Anspruch 20.

## Claims

1. Transparent, chemically temperable or chemically tempered glass ceramic with keatite as the main crystal phase, which has a transmittance of τᵥᵢₛ ≥ 80% at a thickness of 0.7 mm, low haze expressed by haze ≤ 10, preferably < 5, and a crystal phase content of at least 80% by weight of keatite solid solution, preferably at least 90% by weight, particularly preferably at least 95% by weight, based on all crystal phases in the glass ceramic, and contains at least 2% by weight of Li₂O and is substantially free of MgO and substantially free of P₂O₅.

2. Glass ceramic according to Claim 1, **characterized in that** it has SiO₂, Al₂O₃ and Li₂O as main components and SnO₂ and ZrO₂ as nucleating agents.

3. Glass ceramic according to one of Claims 1 or 2, **characterized in that** the SiO₂ content in percent by weight is 58 to 72, preferably 65 to 70.

4. Glass ceramic according to one of the preceding claims, **characterized in that** the Al₂O₃ content in percent by weight is 18 to 23.

5. Glass ceramic according to one of the preceding claims, **characterized in that** the Li₂O content in percent by weight is 2 to 5.5, preferably 3 to 5.

6. Glass ceramic according to one of the preceding claims, **characterized in that** it contains 1 to 2% by weight of SnO₂, preferably 1 to 2.5% by weight of SnO₂, and/or 2 to 3% by weight of ZrO₂.

7. Glass ceramic according to one of the preceding claims, **characterized in that** it contains less than 0.1% by weight of TiO₂, preferably is substantially free of TiO₂.

8. Glass ceramic according to one of the preceding claims, **characterized in that** the ratio of Al₂O₃ to SiO₂, both in percent by weight, is Al₂O₃/SiO₂ < 0.33.

9. Glass ceramic according to one of the preceding claims, **characterized in that** it is substantially free of colouring components, in particular free of V₂O₅, Nd₂O₃, CoO.

10. Glass ceramic according to one of the preceding claims, **characterized in that** it contains 0-2% of B₂O₃.

11. Glass ceramic according to one of the preceding claims, **characterized in that** it contains less than 1% of Na₂O + K₂O.

12. Glass ceramic according to one of the preceding claims, **characterized in that** the condition Li₂O - ZnO - CaO < 3% is met.

13. Glass ceramic according to one of the preceding claims, **characterized in that** it contains less than 2% by weight of BaO, preferably is substantially free of BaO.

14. Glass ceramic according to one of the preceding claims, **characterized in that** it contains less than 1.8% by weight of CaO + SrO, preferably less than 1.5%, wherein the CaO content is preferably 0 to 1% by weight, particularly preferably 0 to 0.8%, and the SrO content is preferably less than 1.8% by weight.

15. Glass ceramic according to one of the preceding claims, **characterized in that** it contains 0 to 2% by weight of ZnO, preferably 0.8 to 2%.

16. Glass ceramic according to one of the preceding claims, **characterized in that** the sum of ZrO₂ + SnO₂ is > 3.6% by weight, preferably > 3.8%.

17. Glass ceramic according to one of the preceding claims, **characterized in that** it contains up to 2% of one or more fining agents selected from As₂O₃, Sb₂O₃, halides, SO₃.

18. Method for producing a tempered glass ceramic according to one of Claims 1 to 16, comprising the following steps:
- producing a silicate green glass by a melting process and subsequent hot shaping
- temperature treatment of the silicate green glass, wherein at least one nucleation step is carried out in the temperature range of 690°C to 850°C for a period of 5 min to 72 h, preferably 30 min to 2 h, and at least one ceramization step is carried out in the temperature range of 780°C to 1100°C for a period of 3 min to 150 h, preferably 3 min to 8 h
- performing at least one ion exchange in an exchange bath having a composition of 100% by weight to 0% by weight KNO₃ and 0% by weight to 100% by weight NaNO₃ and 0% by weight to 5% by weight LiNO₃ at a temperature of the exchange bath between 370°C and 500°C and for a period of between 2 hours and 50 hours.

19. Method according to Claim 18, wherein the hot shaping is carried out by floating, rolling, drawing or ingot casting.

20. Cover pane with a thickness of 0.4 mm to 1 mm produced from a tempered glass ceramic according to one of Claims 1 to 17 or according to a method according to Claim 18 or 19.

21. Use of a cover pane according to Claim 20 and/or of a tempered glass ceramic according to one of Claims 1 to 17 in electronic devices, in particular in electronic display devices, in particular in mobile electronic display devices, for example in mobile touch panels and/or mobile digital display devices such as smartphones or smartwatches.

22. Display device, in particular digital display device, comprising at least one cover pane according to Claim 20.

## Revendications

1. Vitrocéramique transparente, précontrainte chimiquement ou pouvant être précontrainte chimiquement, à kéatite en tant que phase cristalline principale, qui présente une transmission de τᵥᵢₛ ≥ 80 % en une épaisseur de 0,7 mm, un faible trouble exprimé par haze ≤ 10, de préférence < 5, et une proportion de phases cristallines d'au moins 80 % en poids, de préférence d'au moins 90 % en poids, de façon particulièrement préférée d'au moins 95 % en poids de cristal mixte de kéatite, par rapport à toutes les phases cristallines dans la vitrocéramique et qui contient au moins 2 % en poids de Li₂O et est essentiellement exempte de MgO et est essentiellement exempte de P₂O₅.

2. Vitrocéramique selon la revendication 1, **caractérisée en ce qu'**elle comporte SiO₂, Al₂O₃ et Li₂O en tant que composants principaux ainsi que SnO₂ et ZrO₂ en tant qu'agent de nucléation.

3. Vitrocéramique selon l'une quelconque des revendications 1 et 2, **caractérisée en ce que** la teneur en SiO₂ en pour cent en poids vaut de 58 à 72, de préférence de 65 à 70.

4. Vitrocéramique selon l'une quelconque des revendications précédentes, **caractérisée en ce que** la teneur en Al₂O₃ en pour cent en poids vaut de 18 à 23.

5. Vitrocéramique selon l'une quelconque des revendications précédentes, **caractérisée en ce que** la teneur en Li₂O en pour cent en poids vaut de 2 à 5,5, de préférence de 3 à 5.

6. Vitrocéramique selon l'une quelconque des revendications précédentes, **caractérisée en ce qu'**elle contient 1 à 2 % en poids de SnO₂, de préférence 1 à 2,5 % en poids de SnO₂, et/ou 2 à 3 % en poids de ZrO₂.

7. Vitrocéramique selon l'une quelconque des revendications précédentes, **caractérisée en ce qu'**elle contient moins de 0,1 % en poids de TiO₂, de préférence est essentiellement exempte de TiO₂.

8. Vitrocéramique selon l'une quelconque des revendications précédentes, **caractérisée en ce que** le rapport de Al₂O₃ à SiO₂, l'un et l'autre en pour cent en poids, Al₂O₃/SiO₂ est < 0,33.

9. Vitrocéramique selon l'une quelconque des revendications précédentes, **caractérisée en ce qu'**elle est essentiellement exempte de composants colorants, en particulier exempte de V₂O₅, Nd₂O₃, CoO.

10. Vitrocéramique selon l'une quelconque des revendications précédentes, **caractérisée en ce qu'**elle contient 0-2 % de B₂O₃.

11. Vitrocéramique selon l'une quelconque des revendications précédentes, **caractérisée en ce qu'**elle contient moins de 1 % en poids de Na₂O + K₂O.

12. Vitrocéramique selon l'une quelconque des revendications précédentes, **caractérisée en ce que** la condition Li₂O - ZnO - CaO < 3 % est remplie.

13. Vitrocéramique selon l'une quelconque des revendications précédentes, **caractérisée en ce qu'**elle contient moins de 2 % en poids de BaO, de préférence est essentiellement exempte de BaO.

14. Vitrocéramique selon l'une quelconque des revendications précédentes, **caractérisée en ce qu'**elle contient moins de 1,8 % en poids, de préférence moins de 1,5 %, de CaO + SrO, la teneur en CaO valant de préférence 0 à 1 % en poids, de façon particulièrement préférée 0 à 0,8 %, et la teneur en SrO est de préférence inférieure à 1,8 % en poids.

15. Vitrocéramique selon l'une quelconque des revendications précédentes, **caractérisée en ce qu'**elle contient 0 à 2 % en poids, de préférence 0,8 à 2 %, de ZnO.

16. Vitrocéramique selon l'une quelconque des revendications précédentes, **caractérisée en ce que** la somme ZrO₂ + SnO₂ est > 3,6 % en poids, de préférence > 3,8 %

17. Vitrocéramique selon l'une quelconque des revendications précédentes, **caractérisée en ce qu'**elle contient jusqu'à 2 % d'un ou de plusieurs agents d'affinage choisis parmi As₂O₃, Sb₂O₃, les halogénures, SO₃.

18. Procédé pour la fabrication d'une vitrocéramique précontrainte selon l'une quelconque des revendications 1 à 16, comprenant les étapes
production d'un verre précurseur silicaté, par un processus de fusion et un formage à chaud subséquent
- traitement thermique du verre précurseur silicaté, dans lequel sont effectuées au moins une étape de nucléation dans la plage de température de 690 °C à 850 °C pendant une durée de 5 minutes à 72 heures, de préférence de 30 minutes à 2 heures, et au moins une étape de céramisation dans la plage de température de 780 °C à 1 100 °C pendant une durée de 3 minutes à 150 heures, de préférence de 3 minutes à 8 heures
- exécution d'au moins un échange d'ions dans un bain d'échange ayant une composition de 100 % en poids à 0 % en poids de KNO₃ et 0 % en poids à 100 % en poids de NaNO₃ et 0 % en poids à 5 % en poids de LiNO₃ à une température du bain d'échange comprise entre 370 °C et 500 °C et pendant une durée comprise entre 2 heures et 50 heures.

19. Procédé selon la revendication 18, dans lequel le formage à chaud s'effectue par flottage, laminage, étirage ou coulée en bloc.

20. Plaque de recouvrement ayant une épaisseur de 0,4 mm à 1 mm, fabriquée à partir d'une vitrocéramique précontrainte selon l'une quelconque des revendications 1 à 17 ou conformément à un procédé selon la revendication 18 ou 19.

21. Utilisation d'une plaque de recouvrement selon la revendication 20 et/ou d'une vitrocéramique selon l'une quelconque des revendications 1 à 17 dans des appareils électroniques, en particulier dans des appareils d'affichage électroniques, en particulier dans des appareils d'affichage électroniques mobiles, par exemple dans des panneaux tactiles mobiles et/ou des appareils d'affichage numériques mobiles tels que des smartphones ou des montres intelligentes.

22. Appareil d'affichage, en particulier appareil d'affichage numérique, comprenant au moins une plaque de recouvrement selon la revendication 20.
